Europäisches Patentamt

European Patent Office

Office européen des brevets

(19)

(11) Veröffentlichungsnummer : **0 026 337 B2**

(12)
# NEUE EUROPÄISCHE PATENTSCHRIFT

(45) Veröffentlichungstag der neuen Patentschrift :
**15.06.88**

(21) Anmeldenummer : **80105152.5**

(22) Anmeldetag : **29.08.80**

(51) Int. Cl.⁴ : **H 01 J 37/32, C 23 F 1/00, H 01 L 21/302**

(54) Verfahren zum Ätzen von Werkstücken in einer Vakuumkammer.

(30) Priorität : **28.09.79 US 79759**

(43) Veröffentlichungstag der Anmeldung :
**08.04.81 Patentblatt 81/14**

(45) Bekanntmachung des Hinweises auf die Patenterteilung : **22.08.84 Patentblatt 84/34**

(45) Bekanntmachung des Hinweises auf die Entscheidung über den Einspruch : **15.06.88 Patentblatt 88/24**

(84) Benannte Vertragsstaaten :
**DE FR GB IT**

(56) Entgegenhaltungen :
**CH-A- 371 434**
**DE-A- 2 800 180**
**DE-C- 1 052 959**
**US-A- 3 783 822**
**US-A- 3 914 573**
**US-A- 3 984 301**
**Max Wutz "Theorie und Praxis der Vakuumtechnik",**
**F. Vieweg & Sohn, (1965) Braunschweig, Seiten 97-99,**
**Kapitel 3.4.2.1**

(73) Patentinhaber : **International Business Machines Corporation**
**Old Orchard Road**
**Armonk, N.Y. 10504 (US)**

(72) Erfinder : **Hassan, Javathu Kutikaran,**
**55 Wright Boulevard**
**Hopewell Junction, NY 12533 (US)**
Erfinder : **Paivanas, John Angelo**
**10 Hudson Drive**
**Hyde Park, NY 12538 (US)**

(74) Vertreter : **Gaugel, Heinz, Dipl.-Ing.**
**IBM Deutschland GmbH Schönaicher Strasse 220**
**D-7030 Böblingen (DE)**

EP 0 026 337 B2

## Beschreibung

Die Erfindung betrifft ein Verfahren zum Ätzen von Werkstücken in einer Vakuumkammer, in der Elektroden (23, 25) zur Erzeugung einer HF-Glimmentladung und dazwischen eine Trägerplatte (19) für die Werkstücke angeordnet sind, bei dem der Vakuumkammer mittels mindestens einer Düse (41) Ätzgas zugeführt wird, sowie eine Einrichtung zur Durchführung dieses Verfahrens.

Bei der Fertigung von elektronischen Halbleiter-Bauelementen kommt den in einer Vakuumkammer durchgeführten Plasmaätzprozessen grosse Bedeutung zu. Zum Ätzen von Silizium und Siliziumlegierungen, wie Siliziumnitriden und Siliziumoxiden, sowie von Molybdän- und Wolframschichten, wird beispielsweise Ätzgas, vorzugsweise Tetrafluormethan ($CF_4$), im Handel als Freon-Gas bekannt, in eine Vakuumkammer eingeblasen, in welcher zwischen zwei Elektroden eine HF-Glimmentladungsreaktion erzeugt wird. Ein solches Plasmaätzverfahren ist als Trockenätzen bekannt und hat sich als besonders vorteilhaft erwiesen, da auf diese Weise hohe Ätzleistungen bei guter Gleichmässigkeit und hohem Trennvermögen erzielbar sind.

Die DE-OS 2 800 180 und die US-PS 4 094 722 beschreiben Verfahren und Einrichtungen zum Ätzen von Werkstücken in einer Vakuumkammer, in der zwei Elektroden zur Erzeugung einer HF-Glimmentladung und dazwischen eine Trägerplatte für die Werkstücke angeordnet sind, und bei denen in die Vakuumkammer Ätzgas zugeführt wird.

Diese bekannten Verfahren und Einrichtungen zur Durchführung von Trockenätzen sind jedoch hinsichtlich der Gleichmässigkeit der Verteilung der positiven und negativen Ionen in dem starken elektrischen und magnetischen Feld der Reaktionszone unbefriedigend. Die allgemeinen Stromungscharakteristiken von Ätzgasen bei Trockenätzprozessen liegen infolge des verwendeten Hochvakuums im Bereich der Dynamik verdünnter Gase. Insbesondere findet hier die Gasströmung in den Bereichen der freien molekularen Strömung und der Übergangsströmungsbedingungen statt, also zwischen der freien molekularen Strömung und der kontinuierlichen Dauerströmung.

Daher ist das Strömungsverhalten in der Reaktionszone der Vakuumkammer durch vorherrschende Molekularkollisionsphänomene gekennzeichnet. Eine kontinuierliche Dauerströmung ist jedoch unter den Reaktionsbedingungen in Trockenprozessen der beschriebenen Art nicht brauchbar.

Der gegenwärtige Stand der Technologie der Trockenätzverfahren ist, dass unter unterschiedlichen Betriebsbedingungen unterschiedliche Ätzergebnisse auftreten, wobei die Art und die Einheitlichkeit des Gasfeldes in der Reaktionszone um das zu bearbeitende Werkstück herum einen massgeblichen Anteil haben.

Der Erfindung liegt die Aufgabe zugrunde, diese Unregelmässigkeiten in den Ätzprozessen zu verbessern, nämlich für die Reaktionszone eine verbesserte Gasverteilung zu erreichen, welche eine gleichmäßigere Bearbeitung der Werkstückoberfläche gewährleistet. Dabei ist der Grundgedanke der erfindungsgemässen Lösung die folgende Erkenntnis : Man hat bisher geglaubt, dass bei Anwendung von Trockenätzverfahren das Gas durch natürliche Fortbewegungsfaktoren eine gleichmässige Strömungsverteilung erfährt, und zwar unter der Wirkung der Strömungscharakteristiken beim Ausströmen des Gases in die unter Hochvakuum stehende Kammer. Tatsächlich ist jedoch das Strömungbild beim Einsatz von Vakuum äusserst uneinheitlich, und eine wesentliche Verbesserung bei der Erzielung gleichmässiger Ätzwirkungen kann erfindungsgemäss dadurch erreicht werden, dass man das Ätzgas mit Schallgeschwindigkeit in die Reaktionszone der Vakuumkammer einführt.

Durch die US-PS 3 914 573 ist eine Plasmasprühpistole bekannt, mit deren Hilfe Oberflächen mit Materialpartikeln besprüht werden. Die Materialpartikel werden mit Hilfe einer Glimmentladung stark erhitzt und strömen mit einer Geschwindigkeit von 1-3 Mach aus der Plasmasprühpistole aus. Durch die hohe Geschwindigkeit des Plasmastromes sollen eine starke Bindung sowie dichte und gleichmäßige Beschichtungen erzielt werden.

Abweichend von der Erfindung handelt es sich bei diesem Stand der Technik um kein Trockenätzverfahren, das Plasma wird hier im Düsenbereich erzeugt und ein Vakuum ist nicht vorhanden.

Gemäß der Erfindung wird das Ätzgas der Düse bzw. den Düsen z. B. unter einem Druck von $7 \times 10^3$ bis $7 \times 10^4$ Pa zugeführt, der im Vergleich zu dem in der Vakuumkammer herrschenden Unterdruck relativ hoch ist, und die Zuführleitung zur Düse ist so gestaltet, dass das zugeführte Ätzgas beim Austritt aus der Düse Schallgeschwindigkeit erreicht. Dies hat zur Folge, dass die Gasmoleküle im Bereich der Reaktionszone eine starke Verwirbelung erfahren, so dass die zu ätzende Werkstückoberfläche einem gleichmässigen Ätzgasfeld ausgesetzt ist.

Einzelheiten des erfindungsgemässen Verfahrens sowie eine bevorzugte Einrichtung zur Durchführung des Verfahrens werden nachfolgend anhand der Zeichnungen beschrieben. Es zeigen :

Fig. 1 einen Schnitt durch eine Ätzeinrichtung für Halbleitersubstrate,

Fig. 2 eine vergrösserte Draufsicht auf die Düsenanordnung der in Fig. 1 dargestellten Einrichtung,

Fig. 3 eine teilweise geschnittene und teilweise Seitenansicht in der Ebene 3-3 der Fig. 2,

Fig. 4 einen Schnitt in der Ebene 4-4 der Darstellung nach Fig. 2,

Fig. 5 eine Alternativausführung einer Düsenanordnung, mit der zwei Gase in die Einrichtung nach Fig. 1 eingeführt werden können,

Fig. 6 einen vergrösserten Teilschnitt des Endes der Düsenanordnung nach Fig. 5 für die Gasströme A und B,

Fig. 7 einen Schnitt durch eine weitere Ausführungsform einer Düseneinheit für die Einrichtung nach Fig. 1,

Fig. 8 eine Schnittansicht in der Ebene 8-8 der Fig. 7 und

Fig. 9 einen Schnitt durch eine weitere Ausführungsform für eine Düseneinheit ähnlich derjenigen nach Fig. 7, jedoch mit variabler Länge der Düsenleitungen.

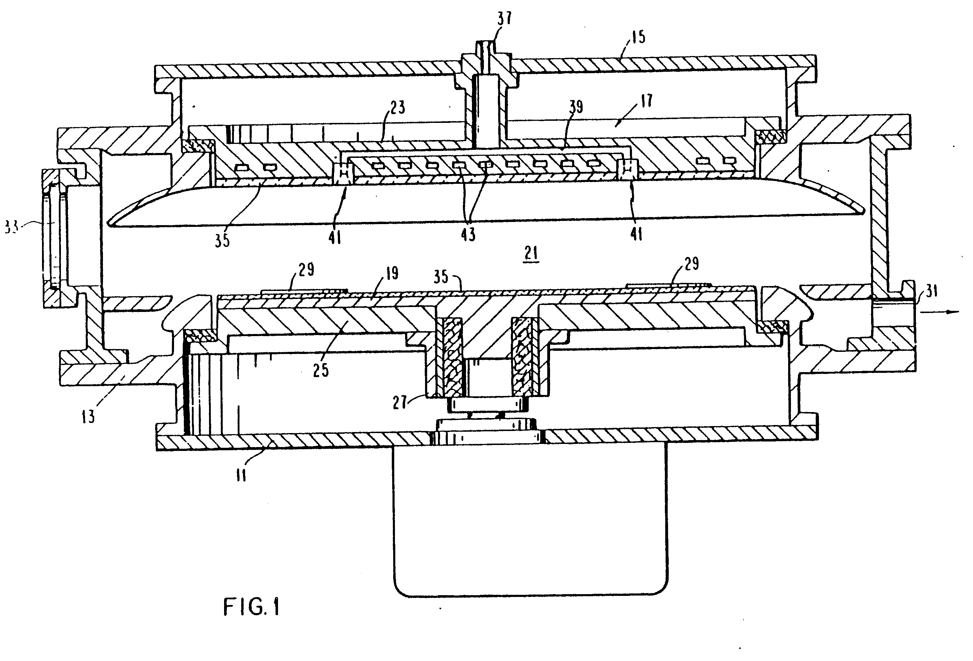

In Fig. 1 ist eine Einrichtung zum Trockenätzen definierter Flächen von Substraten 29 dargestellt, bei denen es sich um Wafer oder sonstige Scheiben aus Halbleitermaterial handeln kann.

Die in Fig. 1 dargestellte Einrichtung besteht aus einer Grundplatte 11, einer Seitenwand 13 und einer Deckplatte 15, welche abgedichtet miteinander verbunden sind und somit eine evakuierbare Kammer bilden. Innerhalb der Kammer ist eine Verteilereinheit 17 angeordnet, und unterhalb derselben befindet sich eine drehbare Trägerplatte 19. Den Raum zwischen der Trägerplatte 19 und der Verteilereinheit 17 bildet eine Reaktionszone 21. Es sind weiterhin eine erste Elektrode 23 und eine zweite Elektrode 25 angeordnet, welche als zueinander parallele, scheibenförmige Platten ausgebildet sind. Die erste Elektrode 23 ist an eine (nicht dargestellte) hochfrequente Stromquelle angeschlossen, und die zweite Elektrode 25 ist geerdet. Ein Antrieb 27 dient zur Erzeugung der Drehbewegung der Trägerplatte 19, um die Substrate in die jeweils gewünschte Position zu bringen. An eine Bohrung 31 ist eine (nicht gezeigte) Vakuumpumpe angeschlossen, wodurch die Reaktionszone evakuiert werden kann. Ein Sichtloch 33 dient zur fortlaufenden Beobachtung des Ätzprozesses. Die obere Fläche der Trägerplatte 19 und die untere Fläche der Verteilereinheit 17 sind zum Schutz gegen die Ätzatmosphäre mit Quarzauflagen 35 versehen. Wenn die Hochfrequenzquelle eingeschaltet und ein geeignetes Gas in die Reaktionszone eingeführt wird, findet eine Glimmentladungsreaktion in dem Raum zwischen den beiden Elektroden 23, 25 statt, wobei die Oberflächen der ersten Elektrode 23 und der Trägerplatte 19 durch die Quarzauflagen 35 geschützt werden.

Die Verteilereinheit 17 weist eine Einlassöffnung 37, eine Verteilerleitung 39 und eine Düseneinheit 41 auf. Eine Anzahl Kühlkanäle 43 dient der Kühlung der Verteilereinheit 17 während des Ätzprozesses.

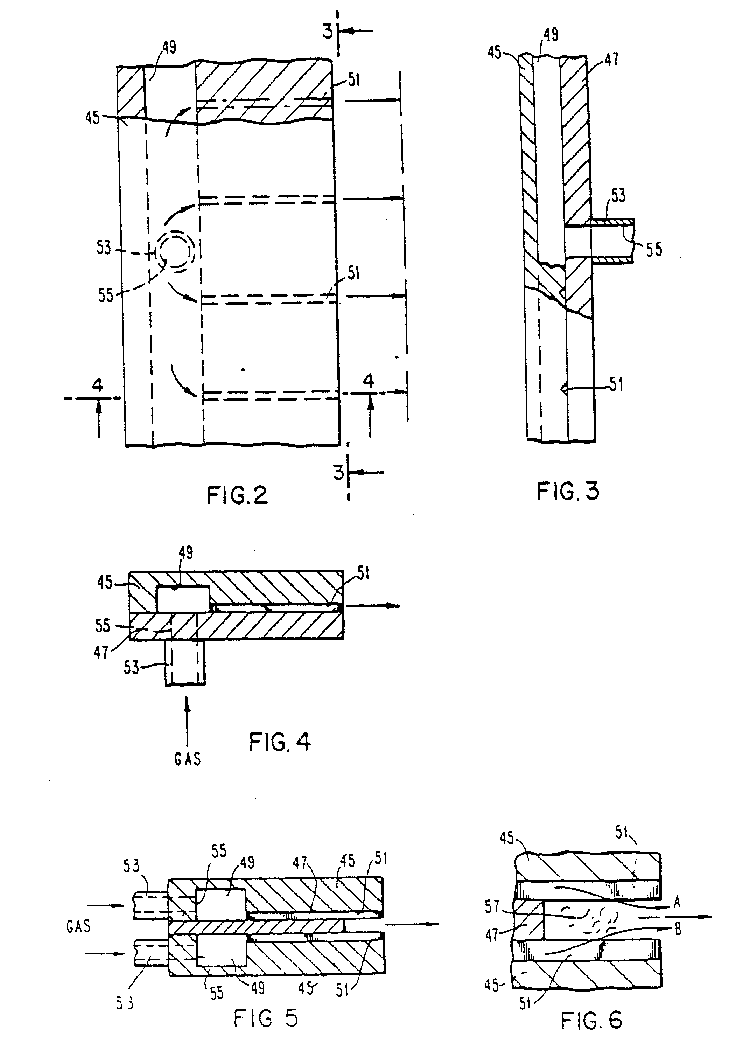

Die Anordnung und Arbeitsweise der Düseneinheit 41 wird nachfolgend anhand der Figuren 2 bis 4 erläutert. Wie diese Figuren zeigen, besteht die Düseneinheit 41 aus einer Leitungsplatte 45 und einer Abdeckplatte 47. In der Leitungsplatte 45 sind ein Kanal 49 und eine Nut 51 geformt. Die Nut 51 schneidet den Kanal 49 und erstreckt sich bis zu der äusseren Kante der Leitungsplatte 45. Die Leitungsplatte 45 ist durch entsprechende Elemente, z. B. Bolzen oder Schrauben (nicht gezeigt), an der Abdeckplatte 47 befestigt. In dieser zusammengesetzten Lage der beiden Elemente bilden der Kanal 49 und die Nuten 51 ein Verteilungssystem mit einer Vielzahl als Düsen wirksamer Kanäle. An der Abdeckplatte 47 befindet sich eine Zuführleitung 53, welche mittels einer Öffnung 55 in der Abdeckplatte 47 mit dem Kanal 49 verbunden ist.

Wie Fig. 3 zeigt, sind die Nuten 51 vorzugsweise mit dem Querschnitt eines gleichschenkligen Dreiecks ausgebildet, welche Form fertigungstechnisch am einfachsten herstellbar ist. Statt dessen sind aber auch andere Querschnittsformen denkbar, wie z. B. ein halbkreisförmiger, rechteckiger, quadratischer oder vieleckiger Nutenquerschnitt. Weiterhin können die einander anliegenden Flächen der Leitungsplatte 45 und der Abdeckplatte 47 rund, ei- oder rautenförmig ausgebildet sein. Werden beide Teile, nämlich die Leitungsplatte 45 und die Abdeckplatte 47, gemeinsam bearbeitet, so ist eine entsprechende Kennzeichnung der paarigen Teile erforderlich. Aus diesem Grunde wird bevorzugt, ausschliesslich die Leitungsplatte 45 zu bearbeiten.

Zur Durchführung eines Trockenätzprozesses in der dargestellten Einrichtung wird Ätzgas von relativ niedrigem absolutem Druck und einem im Verhältnis zum Vakuum in der Vakuumkammer relativen hohen Druck in die durch den Kanal 49 und die Nuten 51 gebildeten Leitungen zugeführt. Der Druck des Ätzgases liegt im Bereich zwischen $7 \cdot 10^3$ und $7 \cdot 10^4$ Pa. Die Zuführleitungen für das Gas sind vorzugsweise von einer Länge im Bereich von 12 bis 25 mm bei einem Querschnitt von $0,12 \times 10^{-2}$ bis $0,3 \cdot 10^{-2}$ mm$^2$. Das Verhältnis der Gasleitungslänge zum Querschnitt liegt im Bereich von $12 \times 10^4$ bis $4 \cdot 10^3$ mm$^{-1}$. Diese Abmessungsparameter für die Gaszuführleitungen ergeben eine Düsenkonfiguration, mit der bei einem relativ geringen absoluten Druck des Ätzgases im Verteilersystem ein Austreten des Ätzgases aus den Düsen mit Schallgeschwindigkeit erreicht wird.

Gaswege mit der Länge, dem Querschnitt und dem Längen-Querschnitt-Verhältnis entsprechend den vorherigen Vorgaben ergeben einen solchen Leitungswiderstand des Gases, dass der Verteilungsdruck über die gesamte Länge des Verteilungssystems im wesentlichen konstant ist. Weiterhin wird auf diese Weise ein Energieverteilungsfaktor erzielt, der den Austritt des Gases aus den Düsen mit Schallgeschwindigkeit bewirkt. Dadurch erreicht man eine explosionsartige Gasentladung, beginnend vom Ende der Düsen, mit der Folge einer starken Verwirbelung und gleichmässigen Verteilung von Gasmolekülen in der Reaktionszone 21.

Fig. 5 zeigt eine Gasdüsenkonstruktion zur Zufuhr von zwei unterschiedlichen Gasen, welche zum Eintritt in die Vakuumkammer gemischt werden. Zu diesem Zweck sind gemäss Fig. 5 zwei Leitungsplatten 45 mit entsprechenden Kanälen und Nuten versehen wie oben bereits beschrieben. Die beiden Leitungsplatten 45 sind mittels eines Metall-Metall-Kontaktes mit einer Abdeckplatte 47 verbunden, wodurch die bereits beschriebenen Gaszuführ- und Verteilerleitungen entstehen.

Die Abdeckplatte 47 endet, wie Fig. 5 weiterhin zeigt, vor den Leitungsplatten 45. Hierdurch wird, wie aus Fig. 6 ersichtlich, ein Mischbereich 57 gebildet, in welchem die beiden Gasarten intensiv miteinander verwirbelt werden und vor dem Austritt in die Reaktionszone 21 ein gleichmässiges Gasgemisch bilden. Der Abstand des Endes der Abdeckplatte 47 vom Ende der Leitungsplatten 45 ist nicht kritisch und kann in der Praxis kleiner, gleich oder grösser als der Abstand zwischen den Enden der Leitungsplatten 45 sein. Das Austreten der beiden Gasmedien mit Schallgeschwindigkeit erzeugt eine starke Verwirbelung der beiden Gase miteinander, unabhängig davon, in welchem Abstand das Ende der Abdeckplatte 47 angeordnet wird.

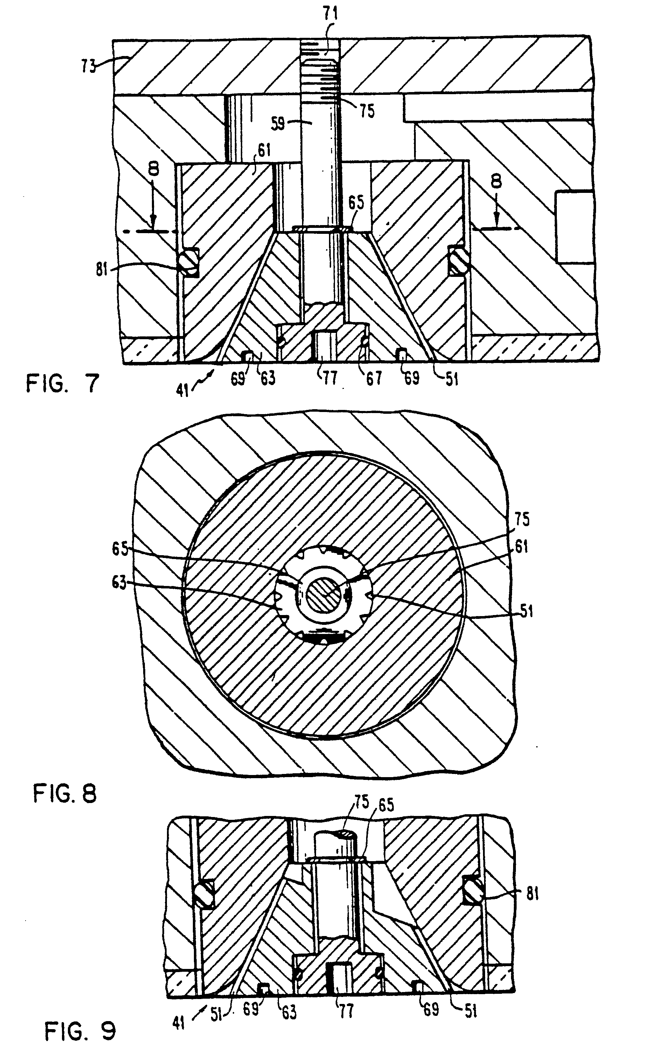

Eine spezielle Ausführung der Düseneinheit 41 ist in Fig. 7 dargestellt. Diese kann als eine Form der Düseneinheit 41 gemäss Fig. 2 angesehen werden, wobei die flache Platte gemäss Fig. 2 als Konus ausgebildet ist. Die in Fig. 7 dargestellte Düseneinheit besteht aus einer Befestigungsschraube 59, einem Düsenkörper 61 und einem Düseneinsatz 63. Wie am besten in Fig. 8 erkennbar, weist der Düseneinsatz 63 dreieckförmige Nuten 51 auf, welche längs der konischen Fläche verlaufen. Die Nuten dienen zur Bildung von Gaskanälen wie bereits zuvor im Zusammenhang mit den Figuren 2 bis 4 beschrieben. Ein Haltering 65 dient für die axiale Halterung der Befestigungsschraube 59 und des Düseneinsatzes 63, während dieser um die Befestigungsschraube 59 drehbar ist. Mittels Spannbohrungen 69 kann der Gewindeeinsatz 63 festgehalten werden, wenn die Befestigungsschraube 59 mit dem Gewindebolzenende 75 in eine Gewindebohrung 71 einer Deckplatte 73 eingeschraubt wird. Um dieses Einschrauben zu bewerkstelligen, ist im Kopf der Befestigungsschraube 59 eine Sechskantbohrung 77 für ein entsprechendes Sechskantwerkzeug vorgesehen.

Zum Zusammensetzen der in Fig. 7 dargestellten Düseneinheit wird zunächst die Befestigungsschraube 59 in den O-Ring 67 des Düseneinsatzes 63 eingeführt, und sodann wird der Haltering 65 aufgeschoben. Der Düseneinsatz 63 ist nun relativ zur Befestigungsschraube 59 drehbar. Anschliessend wird der Düsenkörper 61 montiert, und sodann wird die Befestigungsschraube 59 in die Deckplatte 73 eingeschraubt. Der O-Ring 67 dient zur Abdichtung des Ringraumes zwischen der Befestigungsschraube 59 und dem Düseneinsatz 63.

Sind die Teile in der vorher beschriebenen Weise montiert, so befinden sich die Nuten 51 des Düseneinsatzes 63 benachbart zum Düsenkörper 61, wodurch eine entsprechende Anzahl von Gaskanälen gebildet wird. Ein O-Ring 81 dient zur Verhinderung von Gasdruckverlusten in dem Ringspalt zwischen dem Düsenkörper 61 und dem angrenzenden Gehäuse.

Die Ausführung gemäss Fig. 9 dient dazu, zur Erzielung unterschiedlicher Gasströmungscharakteristiken Gaskanäle von variabler Länge zu bilden. Hier ist der Düseneinsatz als schräg abgeflachter Kegelstumpf ausgebildet, wie Fig. 9 zeigt, an dessen Umfang Nuten 51 eingearbeitet sind. Infolge der schrägen Abflachung des Kegelstumpfes sind die einzelnen Nuten 51 unterschiedlich lang. Wird der so geformte Düseneinsatz, in Fig. 9 gleichfalls mit 63 bezeichnet, in den Düsenkörper eingesetzt, kann die Lage der Nuten entsprechend ihrer unterschiedlichen Länge vorbestimmt werden, bevor die Befestigungsschraube angezogen wird. Es ist zu bemerken, dass, ungeachtet der unterschiedlichen Ausbildung des Düseneinsatzes 63 gemäss Fig. 9, im Hinblick auf die gleiche Funktion der Teile die Bezifferung mit der Ausführung gemäss Fig. 7 übereinstimmt.

## Patentansprüche

1. Verfahren zum Ätzen von Werkstücken in einer Vakuumkammer, in der zwei Elektroden (23, 25) zur Erzeugung einer HF-Glimmentladung und dazwischen eine Trägerplatte (19) für die Werkstücke angeordnet sind, bei dem der Vakuumkammer mittels mindestens einer Düse (41) Ätzgas zugeführt wird, dadurch gekennzeichnet, daß das Gas der/den Düse(n) (41) unter einem Druck von $7 \times 10^3$ bis $7 \times 10^4$ Pa zugeführt wird, und daß das Längen-Querschnittsverhältnis der Düse(n) (41) $2 \times 10^4$ bis $4 \times 10^3$ mm$^{-1}$ beträgt, so daß das Gas mit Schallgeschwindigkeit aus der/den Düse(n) in die Reaktionszone (21) der Vakuumkammer austritt.

2. Einrichtung zur Durchführung des Verfahrens nach Anspruch 1, dadurch gekennzeichnet, daß in der Vakuumkammer den Oberflächen der Werkstücke (29) gegenüberliegend eine an mindestens eine Zuführleitung (53) angeschlossene Verteilereinheit (17) angeordnet ist, die eine aus einer Leitungsplatte (45) mit mindestens einer Nut (51) und aus einer Abdeckplatte (47), welche zur Bildung mindestens einer Leitung mit Düse einander anliegend miteinander verbunden sind, bestehende Düseneinheit (41) aufweist.

3. Einrichtung nach Anspruch 2, dadurch gekennzeichnet, daß die Düse(n) einen Querschnitt von $0,12 \times 10^{-2}$ bis $0,3 \times 10^{-2}$ mm$^2$ und einer Länge von 12 bis 25 mm aufweist/aufweisen.

4. Einrichtung nach Anspruch 2 oder 3, dadurch gekennzeichnet, daß die Düseneinheit aus einem Düsenkörper (61) und einem kegelstumpfförmigen Düseneinsatz (63) besteht, in dessen dem Düsenkörper (61) anliegender Kegelfläche eine Anzahl längsverlaufender Nuten (51) angeordnet ist.

5. Einrichtung nach Anspruch 4, dadurch gekennzeichnet, daß der Düseneinsatz (63) zur Bildung von Düsen unterschiedlicher Länge als abgeschrägter Kegelstumpf gestaltet ist.

**Claims**

1. Method of etching workpieces in a vacuum chamber, where two electrodes (23, 25) to produce an HF glow discharge, and therebetween a carrier plate (19) for the workpieces are arranged, and where etching gas is applied to the vacuum chamber by at least one nozzle (41), characterized in that the gas is introduced into the nozzle(s) (41) at a pressure of $7 \times 10^3$ to $7 \times 10^4$ Pa, and that the length/cross section ratio of the nozzle(s) (41) is $4 \times 10^3$ mm$^{-1}$, so that the gas exits with sonic velocity from the nozzle(s) into the reaction region (21) of the vacuum chamber.

2. Device for carrying out the method as claimed in claim 1, characterized in that in the vacuum chamber opposite to the surfaces of the workpieces (29) a manifold (17) connected to at least one supply line (53) is arranged which comprises a nozzle unit (41) consisting of a conductor plate (45) with at least one groove (51) and of a cover plate (47) which are interconnected to form at least one line with a nozzle.

3. Device as claimed in claim 2, characterized in that the nozzle(s) has (have) a cross section ranging from $0.12 \times 10^{-2}$ to $0.3 \times 10^{-2}$ mm$^2$, and a length ranging from 12 to 25 mm.

4. Device as claimed in claims 2 or 3, characterized in that the nozzle unit consists of a nozzle body (61) and a truncated cone-shaped nozzle insert (63) in whose conic surface placed against the nozzle body (61) a number of longitudinal grooves (51) are arranged.

5. Device as claimed in claim 4, characterized in that the nozzle insert (63) is designed to form nozzles of different length as an obliquely truncated cone.


**Revendications**

1. Procédé pour décaper des pièces dans une enceinte sous vide où sont disposées deux électrodes (23, 25) pour engendrer une décharge lumineuse HF avec entre elles une plaque support (19) pour les pièces selon lequel l'enceinte est alimentée en gaz de décapage à l'aide d'au moins une base (41), caractérisé en ce que le gaz est délivré sous une pression de $7 \cdot 10^3$ à $7 \cdot 10^4$ et en ce que la valeur longueur-section des buses (41) est comprise entre $2 \cdot 10^4$ et $4 \cdot 10^{-3}$ mm$^{-1}$ de manière que le gaz éjecté par les buses dans la zone de réaction (21) ait une vitesse sonique.

2. Dispositif pour la mise en œuvre du procédé conforme à la revendication 1, caractérisé en ce que dans l'enceinte à vide est disposé un distributeur (17) relié à au moins un conduit d'alimentation (53), placé en vis-à-vis de la face supérieure des pièces (29) et qui comprend une entité de buse (41) constituée d'une plaque de conduite (45) avec au moins une rainure (51) et d'une plaque de couvercle qui sont contiguës et reliées l'une à l'autre pour former un conduit avec buse.

3. Dispositif conforme à la revendication 2, caractérisé en ce que les buses ont une section comprise entre 0,12 et $5 \cdot 10^{-2}$ mm$^2$ et une longueur comprise entre 12 et 25 mm.

4. Dispositif conforme à la revendication 2 ou 3, caractérisé en ce que l'entité de buse comprend un corps de buse (61) et un élément de buse (63) en tronc de cône ou une série de rainures longitudinales (51) sont ménagées dans la surface du cône contiguës au corps de buse (61).

5. Dispositif conforme à la revendication 4, caractérisé en ce que l'élément de buse (63) destiné à constituer des buses de différentes longueurs est agencé en tronc de cône biseauté.

FIG.1

FIG.2

FIG. 3

FIG. 4

GAS

FIG 5

GAS

FIG. 6

2

0 026 337

FIG. 7

FIG. 8

FIG. 9

3